# EUROPÄISCHE PATENTSCHRIFT

(11) **EP 4 552 216 B1**
(45) Veröffentlichungstag und Bekanntmachung des Hinweises auf die Patenterteilung: **26.08.2026**
(21) Anmeldenummer: 23744882.4
(22) Anmeldetag: 05.07.2023
(51) Int. Cl.: H03K 17/687

(54) **VERFAHREN UND SCHALTUNG ZUR STROMKONTROLLE**
METHOD AND CIRCUIT FOR CURRENT CONTROL
PROCÉDÉ ET CIRCUIT DE RÉGULATION DE COURANT

(30) Priorität: 06.07.2022 DE 102022116806
(43) Veröffentlichungstag der Anmeldung: 14.05.2025
(73) Patentinhaber: AT-Tronic GmbH, 09350 Lichtenstein / OT Roedlitz (DE)
(72) Erfinder: ZIMMERMANN, Uwe, 09350 Lichtenstein / OT Roedlitz (DE)
(74) Vertreter: Steiniger, Carmen
(86) Internationale Anmeldenummer: PCT/IB2023/056950
(87) Internationale Veröffentlichungsnummer: WO 2024/009230

(56) Entgegenhaltungen:
- EP-A1- 3 159 994
- US-A1- 2015 028 935
- US-B1- 7 154 253
- ANONYMOUS: "Regelungstechnik - Wikipedia", 19 July 2021 (2021-07-19), pages 1 - 32, XP055920199, Retrieved from the Internet <URL:https://de.wikipedia.org/w/index.php?title=Regelungstechnik&oldid=214014187> [retrieved on 20220511]

## Beschreibung

Die vorliegende Erfindung betrifft ein Verfahren zur Stromkontrolle mit einer Schaltung mit einer ersten Last- und/oder Generatorkomponente und einer zweiten Last- und/oder Generatorkomponente, zwischen welchen ein Strom in einer ersten Stromrichtung oder in einer zweiten Stromrichtung fließen kann, und zwei in Reihe zwischen der ersten Last- und/oder Generatorkomponente und der zweiten Last- und/oder Generatorkomponente geschalteten Transistorschaltern, deren Source- bzw. Emitteranschlüsse elektrisch kurzgeschlossen sind, wobei Gatespannungen an Gateanschlüssen der Transistorschalter durch den Transistorschaltern jeweils zugeordnete, analoge Transistorregler eingestellt werden und damit ein Ist-Strom durch die Transistorschalter geregelt wird. Die Erfindung betrifft ferner eine Schaltung zur Stromkontrolle mit einer ersten Last- und/oder Generatorkomponente und einer zweiten Last- und/oder Generatorkomponente, zwischen welchen ein Strom in einer ersten Stromrichtung und in einer zweiten Stromrichtung fließen kann, und zwei zwischen der ersten Last- und/oder Generatorkomponente und der zweiten Last- und/oder Generatorkomponente in Reihe geschalteten Transistorschaltern, deren Source- bzw. Emitteranschlüsse elektrisch kurzgeschlossen sind, und den Transistorschaltern jeweils zugeordneten, analogen Transistorreglern zum Einstellen von Gatespannungen und damit Regeln eines Ist-Stroms durch die Transistorschalter.

Bei klassischen Schaltungen werden typischerweise Spitzenströme zugelassen. Um zu verhindern, dass durch Spitzenströme Schäden an Geräten oder Anlagen auftreten, weisen die entsprechenden Schaltkreise Sicherungen auf, die oberhalb bestimmter Ströme schmelzen und den jeweiligen Stromkreis unterbrechen. Ungeachtet dessen können bei diesen Schaltungen bedingt durch die hohen Ströme beispielsweise EMV-Probleme oder ein verstärkter Schaltungsverschleiß auftreten. Außerdem muss bei den bekannten Systemen die jeweils geschmolzene Sicherung durch eine neue ersetzt werden.

Ferner ist es häufig wichtig, in elektrischen Schaltungen in unterschiedlichen Stromrichtungen unterschiedlich hohe Ströme zuzulassen.

In der Druckschrift EP 3 159 994 A ist eine Schaltung enthalten, bei der zwischen einer Spannungsquelle und einer Last zwei gegenläufig gepolte Dioden angeordnet sind. Über jeder der Dioden ist jeweils ein Transistorschalter vorgesehen. Die Steuerelektrode eines ersten der Transistorschalter erhält ihr Ansteuerungssignal aus dem Ausgangssignal eines ersten Operationsverstärkers, während die Steuerelektrode eines zweiten der Transistorschalter ihr Ansteuerungssignal aus dem Ausgangssignal eines zweiten Operationsverstärkers erhält. Dabei erhalten die Ansteuer-Eingänge der beiden Operationsverstärker die gleiche, feste, unveränderbare Ausgangsspannung einer internen analogen Spannungsversorgung. Diese Spannungsversorgung liegt auf einem festen Bezugspotential. Auf diesem festen Bezugspotential liegen auch die Plus-Eingänge der beiden Operationsverstärker.

Die Operationsverstärker greifen jeweils separat voneinander eine Spannung über separat voneinander angeordneten Shunts ab, die einseitig mit dem festen Bezugspotential verbunden sind. Dabei entstehen an den jeweiligen Eingängen der Operationsverstärker zwei unterschiedliche Spannungsabfälle im Vorzeichen und gegebenenfalls im Betrag in Abhängigkeit von dem jeweils zugehörigen Shunt bzw. dessen Wert. Die Operationsverstärker bilden also zwei Strommesseinrichtungen aus.Durch analogen Vergleich der Spannung, die über dem durch einen ersten Strom durchflossenen ersten Shunt abfällt, mit einer festen Steuerspannung erzeugt der erste Operationsverstärker ein Ansteuersignal für den ersten Transistorschalter, während der zweite Operationsverstärker durch analogen Vergleich der gleichen festen Steuerspannung mit der Spannung, die über dem durch einen zweiten Strom durchflossenen zweiten Shunt abfällt, ein Ansteuersignal für den zweiten Transistorschalter erzeugt.

In dem Wikipedia-Artikel "Regelungstechnik" vom 19.07.2021, Seiten 1-32, URL:https://de.wikipedia.org/w/index.php?title=Regelungstechnik&oldid=214014187 wird gesagt, dass Steuerungs- oder Regelungssysteme durch Analogtechnik oder Digitaltechnik realisiert werden können.

In der Druckschrift US 7 154 253 B1 ist eine Schaltung beschrieben, bei der ein DA-Konverter verwendet wird, um ein Signal an einen Schalter zum Limitieren eines Stromwertes zu übermitteln. Dabei erhält der DA-Konverter irgendein digitales Signal und gibt dieses als positive Spannung an einen Plus-Eingang eines ersten Operationsverstärkers weiter, über den dann ein Transistorschalter angesteuert wird. An einen Minus-Eingang des ersten Operationsverstärkers führt das Ausgangssignal eines zweiten Operationsverstärkers, der eine Spannung über einem Widerstand abgreift. Erreicht das Signal des zweiten Operationsverstärkers das Niveau des Signals von dem DA-Konverter, schaltet der erste Operationsverstärker den Transistorschalter ab, sodass hierdurch der Ausgangsstrom der Schaltung begrenzt werden kann. Mit der gezeigten Schaltung ist jedoch nur eine Begrenzung des Ausgangsstroms in eine einzige Richtung möglich. Aus dieser Druckschrift ist ferner entnehmbar, dass in der Schaltungstechnik grundsätzlich eine Kombination von DA- bzw. AD-Wandlern mit einem Controller möglich ist.

In der Druckschrift US 2015/028935 A1 sind rein analog arbeitende Stromunterbrecherschaltungen sowie eine Stromunterbrecherschaltung mit analogen und digitalen Komponenten, welche durch einen AD-Konverter gekoppelt sind, gezeigt. Dabei generiert eine digitale Entscheidungseinheit ein Steuersignal für einen Transistor, aufgrund dessen der Transistor in Abhängigkeit von einem digitalen Vergleich zwischen Eingangswerten und in Speichervorrichtungen gespeicherten Maximalwerten an- und abschalten kann. Damit kann eine Strombegrenzung realisiert werden.

In der Druckschrift WO 2020/165215 A1 ist ein elektrischer Schalter mit Stromregulierung beschrieben. Hierfür ist zwischen eine Energiequelle und einen Verbraucher ein Halbleiterschalter in Form von zwei in Reihe geschalteten Transistoren, deren Source-Anschlüsse kurzgeschlossen sind, eingebunden. In Reihe zu dem Halbleiterschalter ist ein Stromsensor vorgesehen. Die Gates der Transistoren werden durch eine Ansteuerschaltung in Abhängigkeit von dem mit dem Stromsensor erfassten Strom angesteuert. Dabei kann der Strom, den der Verbraucher aufnimmt, durch eine Pulsweitenmodulation begrenzt werden.

Aus der Druckschrift WO 2018/172134 A1 ist ein Verfahren zum Steuern eines zwischen einer Energiequelle und einem elektrischen Verbraucher befindlichen Gleichstromschalters bekannt. Der Gleichstromschalter weist zwei in Reihe geschaltete Transistorschalter auf, deren Source-Anschlüsse kurzgeschlossen sind und deren Gates durch eine Steuervorrichtung in Abhängigkeit von den Messwerten einer in Reihe zu den Transistorschaltern geschalteten Strommessvorrichtung angesteuert werden. Die Steuervorrichtung ist über eine Schnittstelle mit einer übergeordneten Steuerung verbunden. Bei dem Verfahren kann jeder der Transistorschalter einzeln abgeschaltet werden. Ferner ist es mit der beschriebenen Schaltung möglich, beispielsweise die Auslöseschwelle des Gleichstromschalters für netzseitige Fehlerströme 25 % höher als die Auslöseschwelle für lastseitige Fehlerströme zu legen.

Es gibt bisher keine geeigneten Schaltungen, die mit minimalem Schaltungsaufwand die jeweilige Stromhöhe in unterschiedlichen Stromrichtungen begrenzen können.

Es ist daher die Aufgabe der vorliegenden Erfindung, ein Verfahren und eine einfache Schaltung zur Stromkontrolle zur Verfügung zu stellen, mit welchen besonders sicher und effektiv Strompfade definiert und/oder Kurzschlussströme begrenzt werden können.

Die Aufgabe wird zum einen durch ein Verfahren zur Stromkontrolle mit einer Schaltung mit einer ersten Last- und/oder Generatorkomponente und einer zweiten Last- und/oder Generatorkomponente, zwischen welchen ein Strom in einer ersten Stromrichtung oder in einer zweiten Stromrichtung fließen kann, und zwei in Reihe zwischen der ersten Last- und/oder Generatorkomponente und der zweiten Last- und/oder Generatorkomponente geschalteten Transistorschaltern, deren Source- bzw. Emitteranschlüsse elektrisch kurzgeschlossen sind, wobei Gatespannungen der Transistorschalter durch den Transistorschaltern jeweils zugeordnete, analoge Transistorregler eingestellt und damit ein Ist-Strom durch die Transistorschalter geregelt wird, gelöst, wobei der Ist-Strom mit einer Strommesseinrichtung zwischen den Transistorschaltern gemessen wird, dieser an die Transistorregler übergeben wird, wobei der Ist-Strom oder der verstärkte Ist-Strom einem ersten der Transistorregler als erstes Eingangssignal des ersten Transistorreglers und invertiert einem zweiten der Transistorregler als erstes Eingangssignal des zweiten Transistorreglers übergeben wird, den Transistorreglern durch einen digitalen Controller jeweils ein erster Soll-Strom für die erste Stromrichtung und ein zweiter Soll-Strom für die zweite Stromrichtung vorgegeben wird, und von den Transistorreglern in Abhängigkeit von der jeweiligen Differenz zwischen dem Ist-Strom und dem jeweiligen Soll-Strom entsprechende Gatespannungen für die Transistorschalter eingestellt und damit der Ist-Strom durch die Transistorschalter geregelt wird.

Das erfindungsgemäße Verfahren arbeitet in einfachster Form wie folgt:
Zwischen der ersten Last- und/oder Generatorkomponente und der zweiten Last- und/oder Generatorkomponente kann ein Strom sowohl in einer ersten Stromrichtung von der ersten zu der zweiten Last- und/oder Generatorkomponente als auch in einer zweiten Stromrichtung von der zweiten zu der ersten Last- und/oder Generatorkomponente fließen.

Die in Reihe zwischen die erste und die zweite Last- und/oder Generatorkomponente geschalteten Transistorschalter befinden sich dann, wenn kein Fehler in der Schaltung vorliegt, in der Sättigung, das heißt, sie lassen den jeweiligen Strom in beide der Stromrichtungen fließen. Dadurch dass die Source- bzw. Emitteranschlüsse der beiden Transistorschalter kurzgeschlossen sind, können sie durch entsprechende Gateansteuerung als Schalter dienen, die den Strom entweder nur in der ersten Stromrichtung oder nur in der zweiten Stromrichtung durchlassen. In diesen Fällen ist jeweils nur einer der beiden Transistorschalter geschlossen, d. h. in der Sättigung, während der andere sperrt.

Mit der Strommesseinrichtung wird ein Strom, der zwischen der ersten und der zweiten Last- und/oder Generatorkomponente oder umgekehrt fließt und an einem Bezugspunkt zwischen den Transistorschaltern abgegriffen wird, als jeweiliger Ist-Strom gemessen.

Vorzugsweise wird der Ist-Strom durch einen in Reihe zu dem Strommessgerät geschalteten Strommessverstärker verstärkt. Der Strommessverstärker ist dann in Reihe zwischen die Strommesseinrichtung und den jeweiligen Transistorregler geschaltet.

Der Ist-Strom bzw. der verstärkte Ist-Strom wird einem ersten der Transistorregler als erstes Eingangssignal des ersten Transistorreglers und invertiert einem zweiten der Transistorregler als erstes Eingangssignal des zweiten Transistorreglers übergeben.

Als jeweils zweites Eingangssignal wird von dem digitalen Controller dem ersten Transistorregler ein erster Soll-Strom in der ersten Stromrichtung und dem zweiten Transistorregler ein zweiter Soll-Strom in der zweiten Stromrichtung vorgegeben. Der jeweilige Soll-Strom gibt vor, wie hoch der Strom zwischen der ersten Last- und/oder Generatorkomponente und der zweiten Last- und/oder Generatorkomponente in der ersten Stromrichtung bzw. in der zweiten Stromrichtung maximal sein darf.

Jeder der beiden analogen Transistorregler erzeugt ein Ausgangssignal in Form einer dem jeweils zugeordneten Transistorschalter zugeführten Gatespannung. Die jeweiligen Ausgangssignale der beiden Transistorregler sind dabei abhängig von der Differenz zwischen jeweiligem Ist- und Soll-Strom. Die Verwendung analoger Transistorregler ermöglicht bei der vorliegenden Erfindung eine kontinuierliche und sehr schnelle Reaktion in Echtzeit auf einen sich ändernden Ist-Strom, was einen wesentlichen Vorteil im Vergleich zu den aus dem Stand der Technik, wie der WO 2020/165215 A1 oder der WO 2018/172134 A1, bekannten digitalen Ansteuerungen von Transistorschaltern darstellt.

Eine Pulsweitenmodulation findet bei der vorliegenden Erfindung nicht statt. Stattdessen erfolgt bei dem erfindungsgemäßen Verfahren eine Strombegrenzung über eine lineare Ansteuerung der Transistorschalter. Das heißt, die Transistorschalter sind während der Strombegrenzung über die Transistorregler im Linearbereich und nicht pulsweitenmoduliert. Während in der Druckschrift WO 2020/165215 A1 die Strombegrenzung über eine Pulsweitenmodulation erfolgt, wobei die zu übertragende Energie über das Pulsweitenverhältnis begrenzt wird, wird bei der vorliegenden Erfindung die Energie zur bzw. während der Strombegrenzung in den Transistorschaltern über die Verlustleistung der Transistorschalter umgesetzt.

Überschreitet bei der vorliegenden Erfindung der Ist-Strom wenigstens einen durch den digitalen Controller für eine der Stromrichtungen vorgegebenen Soll-Strom, können die Transistorregler die Transistorschalter jeweils so ansteuern, dass der jeweilige Strom durch den jeweiligen Transistor auf den Soll-Strom limitiert wird oder sogar die jeweilige Stromrichtung gesperrt wird.

Dadurch dass die Transistorregler analog arbeiten, kann eine solche Limitierung oder Sperrung kontinuierlich und in Echtzeit erfolgen. Somit können Bauelemente der Schaltung vor Spitzenströmen und damit vor Zerstörung geschützt werden, ohne dass erst eine Sicherung schmelzen muss. Die Strombelastung der Bauelemente der Schaltung kann somit zeitlich minimiert werden. Dies führt zu einer hohen Sicherheit.

Vorzugsweise wird der Ist-Strom kontinuierlich an den digitalen Controller übermittelt.

In einer vorteilhaften Ausführungsform des erfindungsgemäßen Verfahrens werden Spannungsabfälle über der ersten Last- und/oder Generatorkomponente und über der zweiten Last- und/oder Generatorkomponente erfasst und dem digitalen Controller übermittelt.

In einer geeigneten Weiterbildung des erfindungsgemäßen Verfahrens übermittelt der Controller kontinuierlich den Ist-Strom und gegebenenfalls die Spannungsabfälle über der ersten Last- und/oder Generatorkomponente und über der zweiten Last- und/oder Generatorkomponente über einen eine galvanische Trennung ausbildenden Digitalkoppler an eine externe Steuereinheit.

Vorzugsweise wird dann, wenn der Ist-Strom über eine vorbestimmte Zeitspanne hinweg den jeweils vorgegebenen Soll-Strom überschreitet, durch den digitalen Controller ein Ausschaltsignal an wenigstens einen der Transistorregler übermittelt.

In einer optionalen Gestaltung des erfindungsgemäßen Verfahrens wird dann, wenn der Ist-Strom über eine vorbestimmte Zeitspanne hinweg den jeweils vorgegebenen Soll-Strom überschreitet und der Spannungsabfall über der diesem Soll-Strom zugeordneten Last- und/oder Generatorkomponente einen Spannungssollwert unterschreitet, durch den digitalen Controller der jeweilige Soll-Strom auf null gesetzt.

In einer weiteren vorteilhaften Variante des erfindungsgemäßen Verfahrens wird dann, wenn die Schaltung ausgeschaltet wird, durch den digitalen Controller der Soll-Strom rampen- oder stufenförmig verringert.

Ferner ist es gemäß einer Ausführungsform des erfindungsgemäßen Verfahrens möglich, dass dann, wenn die Schaltung eingeschaltet wird, der Soll-Strom rampen- oder stufenförmig erhöht wird.

Die Soll-Strom-Vorgabe durch den digitalen Controller kann für beide Stromrichtungen symmetrisch oder unsymmetrisch sein. Wird jedem der Transistorregler ein eigener Soll-Strom vorgegeben, können strompfadabhängig unterschiedliche Spitzenströme zugelassen werden.

Die Aufgabe wird ferner durch eine Schaltung zur Stromkontrolle mit einer ersten Last- und/oder Generatorkomponente und einer zweiten Last- und/oder Generatorkomponente, zwischen welchen ein Strom in einer ersten Stromrichtung oder in einer zweiten Stromrichtung fließen kann, und zwei in Reihe zwischen der ersten Last- und/oder Generatorkomponente und der zweiten Last- und/oder Generatorkomponente geschalteten Transistorschaltern, deren Source- bzw. Emitteranschlüsse elektrisch kurzgeschlossen sind, und den Transistorschaltern jeweils zugeordneten, analogen Transistorreglern zum Einstellen von Gatespannungen und damit Regeln eines Ist-Stroms durch die Transistorschalter, gelöst, wobei zur Messung des Ist-Stroms zwischen die Transistorschalter eine Strommesseinrichtung geschaltet ist, deren Ausgang mit jeweiligen Reglereingängen der Transistorregler zum Übermitteln des jeweils gemessenen Ist-Stroms verbunden ist, wobei der Ist-Strom oder der verstärkte Ist-Strom einem ersten der Transistorregler als erstes Eingangssignal des ersten Transistorreglers und invertiert einem zweiten der Transistorregler als erstes Eingangssignal des zweiten Transistorreglers übergeben wird, und Reglereingänge der Transistorregler mit einem digitalen Controller zur Vorgabe wenigstens eines Soll-Stroms verbunden sind.

Bei der erfindungsgemäßen Schaltung ersetzen die Transistorschalter elektromechanische Sicherungen und verbessern darüber hinaus deren Funktion. Grundsätzlich ist es jedoch möglich, die erfindungsgemäße Schaltung als Redundanz zu einer Schmelzsicherung zu verwenden. Umgekehrt kann auch wenigstens eine Schmelzsicherung in der erfindungsgemäßen Schaltung zusätzlich eingesetzt werden.

Dadurch dass bei der erfindungsgemäßen Schaltung die Strommesseinrichtung zur Messung des Ist-Stromes in Reihe zwischen die Transistorschalter geschaltet ist, ergibt sich eine einfache, symmetrische Schaltungsanordnung, die eine einfache Signalaufbereitung und eine einfache Koordinierung der Transistorregler ermöglicht. Zudem sind hierdurch die Messung und die Reaktion auf die Messung sehr schnell.

Indem bei der erfindungsgemäßen Schaltung zwei separate Transistorregler zum Einsatz kommen, können unterschiedliche Strombegrenzungswerte für die jeweilige Stromrichtung ermöglicht werden. Damit ist es in der vorliegenden Erfindung möglich, z. B. den Stromfluss nur in eine Richtung zu "erlauben" und in die andere Richtung zu "verbieten" oder zu limitieren.

In einer bevorzugten Ausführungsform der erfindungsgemäßen Schaltung ist parallel zu der ersten Last- und/oder Generatorkomponente ein erstes Spannungsmessgerät und ist parallel zu der zweiten Last- und/oder Generatorkomponente ein zweites Spannungsmessgerät geschaltet.

Die Transistorschalter sind vorteilhafterweise Halbleitertransistoren, wie z. B. MOSFETs oder IGBTs.

Vorzugsweise sind die Transistorregler jeweils Pl- oder PID-Regler mit Operationsverstärker.

In einer vorteilhaften Ausführungsform der erfindungsgemäßen Schaltung sind die Transistorregler und die Transistorschalter aus mehreren, parallel zueinander geschalteten Transistorregler- und Transistorschaltereinheiten zusammengesetzt.

In einer günstigen Variante der erfindungsgemäßen Schaltung ist wenigstens einer der Transistorschalter aus mehreren, parallel zueinander geschalteten Halbleitertransistoren zusammengesetzt.

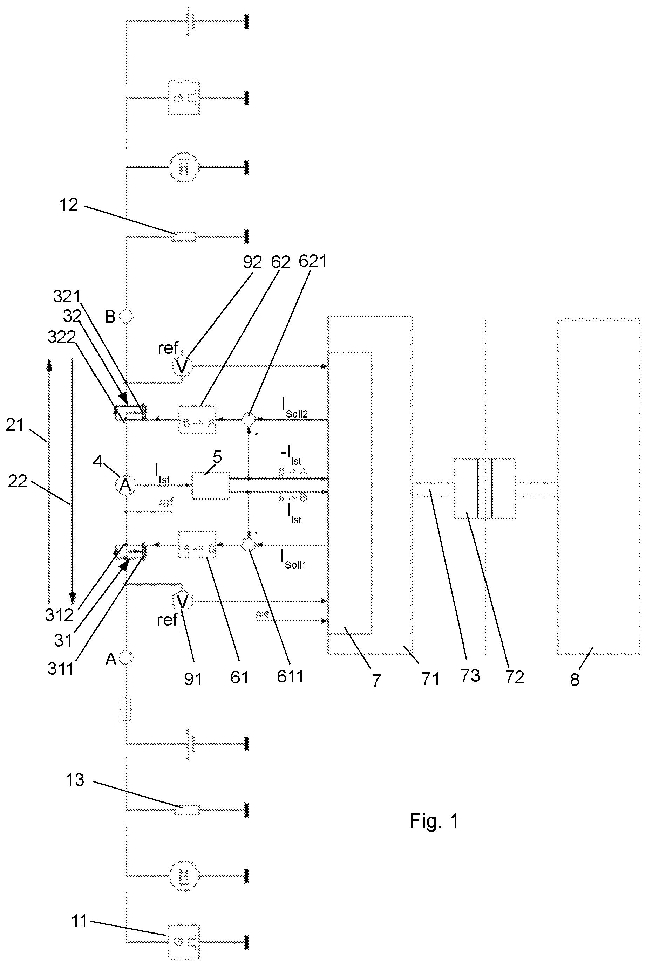

Eine bevorzugte Ausführungsform der vorliegenden Erfindung, deren Aufbau, Funktion und Vorteile werden im Folgenden anhand von Figur 1 näher erläutert.

Figur 1 zeigt eine Ausführungsform einer erfindungsgemäßen Schaltung 1. Die Schaltung 1 weist eine erste Last- und/oder Generatorkomponente 11 und eine zweite Last- und/oder Generatorkomponente 12 auf. In dem gezeigten Ausführungsbeispiel ist die erste Last- und/oder Generatorkomponente 11 ein Generator, kann aber auch, wie es schematisch dargestellt ist, ein Motor, wenigstens ein Widerstand, der ein einzelner Widerstand oder aus mehreren Widerständen zusammengesetzt sein kann und sowohl induktive als auch kapazitive Widerstandsanteile aufweisen kann, und/oder eine Batterie sein. Ferner ist in dem gezeigten Ausführungsbeispiel die zweite Last- und/oder Generatorkomponente 12 ein Widerstand, kann aber auch, wie es schematisch dargestellt ist, ein Motor, ein Generator und/oder eine Batterie sein.

Zwischen der ersten Last- und/oder Generatorkomponente 11 und der zweiten Last- und/oder Generatorkomponente 12 kann grundsätzlich ein Strom in einer ersten Stromrichtung 21, also in der Figur von A nach B, als auch in einer zweiten Stromrichtung 22, also in der Figur von B nach A, fließen.

In Reihe zwischen die erste Last- und/oder Generatorkomponente 11 und die zweite Last- und/oder Generatorkomponente 12 sind ein erster Transistorschalter 31 und ein zweiter Transistorschalter 32 geschaltet. Die Transistorschalter 31, 32 sind in der gezeigten Ausführungsform MOSFETs, können aber auch beispielsweise IGBTs sein. Die Transistorschalter 31, 32 weisen in der gezeigten Ausführungsform einen gemeinsamen Source-Anschluss (common source) auf. Werden für die Transistorschalter 31, 32 anstelle von MOSFETs IGBTs verwendet, liegen deren Emitter auf einem gemeinsamen elektrischen Potenzial.

Das gemeinsame Source- oder Emitterpotenzial der Transistorschalter bildet ein Bezugspotenzial ref für nachfolgend noch näher beschriebene Transistorregler 61, 62 der Schaltung 1. Das Bezugspotenzial ref kann Masse oder ein anderes Potenzial sein.

Zwischen den beiden Transistorschaltern 31, 32 ist eine Strommesseinrichtung 4 geschaltet, mit der ein Ist-Strom I_{Ist} messbar ist. Der Ist-Strom I_{Ist} fließt entweder in der ersten Stromrichtung 21 oder in der zweiten Stromrichtung 22.

In der in Figur 1 gezeigten Ausführungsform ist der Strommesseinrichtung 4 ein Strommessverstärker 5 nachgeschaltet, mit dem der gemessene Ist-Strom I_{Ist} verstärkt und dessen Signal umgekehrt werden kann.

Die Schaltung 1 weist einen mit einem Gateanschluss 311 des ersten Transistorschalters 31 verbundenen ersten Transistorregler 61 und einen mit einem Gateanschluss 321 des zweiten Transistorschalters 32 verbundenen zweiten Transistorregler 61 auf. Die Transistorregler 61, 62 sind beispielsweise Pl- oder PID-Regler mit Operationsverstärker.

Der gemessene und gegebenenfalls verstärkte Ist-Strom I_{Ist} wird an einen Reglereingang 611 des ersten Transistorreglers 61 übergeben, während der gemessene, gegebenenfalls verstärkte und invertierte Ist-Strom -I_{Ist} an einen Reglereingang 621 des zweiten Transistorreglers 62 übergeben wird.

Die Schaltung 1 weist darüber hinaus einen digitalen Controller 7 auf. Der digitale Controller 7 ist mit dem Strommessverstärker 5 bzw. in anderen Ausführungsformen direkt mit der Strommesseinrichtung 4 verbunden, er ist ferner mit den Reglereingängen 611, 621 der Transistorregler 61, 62 verbunden. An den digitalen Controller 7 werden der Ist-Strom I_{Ist} und der invertierte Ist-Strom -I_{Ist} übermittelt. Von dem digitalen Controller 7 wird über einen in der Schaltung 1 nicht extra dargestellten D/A-Wandler ein Soll-Strom I_{Soll1} als erste Führungsgröße an den Reglereingang 611 des ersten Transistorreglers 61 und auch über einen D/A-Wandler ein Soll-Strom I_{Soll2} als zweite Führungsgröße an den Reglereingang 621 des zweiten Transistorreglers 62 übermittelt. Der jeweilige Soll-StromWert I_{Soll1}, I_{Soll2} entspricht der Höhe eines maximalen Stroms, dem es erlaubt wird, in der Stromrichtung 21 bzw. in der Stromrichtung 22 der Schaltung 1 zu fließen. Die Soll-Ströme I_{Soll1}, I_{Soll2} können gleich oder auch unterschiedlich hoch sein. In jedem Fall wird jedoch beiden Transistorreglern 61, 62, also beiden Regelkanälen, ein Soll-Strom I_{Soll1}, I_{Soll2} als Führungsgröße vorgegeben.

In der Schaltung 1 ist parallel zu der ersten Last- und/oder Generatorkomponente 11 ein erstes Spannungsmessgerät 91 und ist parallel zu der zweiten Last- und/oder Generatorkomponente 12 ein zweites Spannungsmessgerät 92 geschaltet. Mit dem ersten Spannungsmessgerät 91 wird eine über der ersten Last- und/oder Generatorkomponente 11 abfallende Spannung ermittelt und an den digitalen Controller 7 übermittelt. Mit dem zweiten Spannungsmessgerät 92 wird eine über der zweiten Last- und/oder Generatorkomponente 12 abfallende Spannung ermittelt und an den digitalen Controller 7 übermittelt.

Der digitale Controller 7 ist über eine Schnittstelle 71, einen Digitalkoppler 72 und Kommunikationskanäle 73 mit einer externen Steuereinheit 8 verbunden. Der Digitalkoppler 72 bildet eine galvanische Trennung zwischen dem digitalen Controller 7 und der externen Steuereinheit 8 aus. Über die externe Steuereinheit 8, in welche noch weitere Daten, wie beispielsweise Temperaturmesswerte aus der Schaltung 1, eingehen können, kann beispielsweise eine Diagnose der Transistorschalter 31, 32 erfolgen.

Wie es beispielhaft in Figur 1 gezeigt ist, kann die Schaltung 1 noch deutlich mehr Bauelemente oder andere Schaltungsbestandteile, wie eine in Reihe zwischen die erste Last- und/oder Generatorkomponente 11 und die zweite Last- und/oder Generatorkomponente 12 geschaltete Schmelzsicherung 13, aufweisen.

In Abhängigkeit von der Differenz zwischen dem Ist-Strom I_{Ist} und dem jeweiligen Soll-Strom I_{Soll1}, I_{Soll2} wird durch den ersten Transistorregler 61 eine Gatespannung für das Gate 311 des ersten Transistorschalters 31 vorgegeben. Durch den zweiten Transistorregler 62 wird eine Gatespannung für das Gate 321 des zweiten Transistorschalters 32 vorgegeben.

Bei der vorliegenden Erfindung fungieren die Transistorregler 61, 62 als innere Regler, die zusammen mit den jeweils zugeordneten Transistorschaltern 31, 32 beispielsweise einen Kurzschlussstrom in der Schaltung 1 (siehe das unten aufgeführte Beispiel 1) limitieren. Der digitale Controller 7 wirkt als äußerer Regler, der den gleichen Ist-Strom I_{Ist} wie die Transistorregler 61, 62 erfasst, diesen aber - je nach Ausführungsform der Erfindung - zusätzlich bewertet.

Verschiedene Ausführungsformen des erfindungsgemäßen Verfahrens sollen im Folgenden anhand von Beispielen im Hinblick auf die Schaltung 1 aus Figur 1 verdeutlicht werden:

### Beispiel 1:

Wird durch den digitalen Controller 7 als I_{Soll1} und als I_{Soll2} beispielsweise ein Wert von 100 A vorgegeben und beträgt der durch die Strommesseinheit 4 gemessene Ist-Strom I_{Ist} 200 A, greifen sofort beide Transistorregler 61, 62 ein und setzen die Gatespannungen beider Transistorschalter 31, 32 auf solche Werte, dass beide Transistorschalter 31, 32 den Ist-Strom I_{Ist} auf 100 A limitieren, also keinen größeren Stromfluss als 100 A mehr in den Stromrichtungen 21, 22 zulassen. Damit begrenzen die Transistorregler 61, 62 zusammen mit den Transistorschaltern 31, 32 schon im Aufkommen eines Kurzschlusses den durch die Schaltung 1 fließenden Strom. Der Ist-Strom I_{Ist} kann jedenfalls nicht weiter steigen. Die Schnelligkeit der Reaktion der Schaltung 1 ergibt sich vor allem dadurch, dass die Transistorregler 61, 62 als auch die Transistorschalter 31, 32 analog arbeiten und den Transistorreglern 61, 62 kontinuierlich der jeweils gemessene Ist-Strom I_{Ist} übermittelt wird.

### Beispiel 2:

In einer Weiterbildung der Erfindung wird der jeweils gemessene Ist-Strom I_{Ist} kontinuierlich an den digitalen Controller 7 übermittelt. Wenn durch den digitalen Controller 7 festgestellt wird, dass ein sich aus den gemessenen Ist-Strom-Werten I_{Ist} und der zugehörigen Zeit ergebender Energiebetrag einen Maximalenergiebetrag überschreitet, wird den Transistorreglern 61, 62 durch den digitalen Controller 7 ein Abschaltsignal für die Transistorschalter 31, 32 übermittelt. In diesem Ausführungsbeispiel wird den Transistorreglern 61, 62 nicht nur jeweils ein Soll-Strom I_{Soll1}, I_{Soll2}, sondern indirekt über das Abschaltsignal eine Vorgabe aus Soll-Strom I_{Soll1}, I_{Soll2} und Zeit übermittelt. Das heißt, dann gibt der Controller 7 vor, wie lange der jeweilige Soll-Strom I_{Soll1}, I_{Soll2} in der Schaltung 1 überschritten werden darf. Erst bei der Überschreitung der jeweiligen Soll-Strom-ZeitVorgabe kommt es dann mittels der Transistorregler 61, 62 zum Abschalten der Transistorschalter 31, 32.

### Beispiel 3:

In dem obigen Beispiel 1 wird zwar in der Schaltung 1 der Ist-Strom I_{Ist} mittels der Transistorschalter 31, 32 begrenzt, ein gegebenenfalls in der Schaltung 1 bestehender Kurzschluss besteht jedoch fort.

Daher werden in einer weiteren Ausführungsform des erfindungsgemäßen Verfahrens mit den Spannungsmessgeräten 91, 92 die Spannungsabfälle über der ersten Last- und/oder Generatorkomponente 11 und über der zweiten Last- und/oder Generatorkomponente 12 erfasst und die entsprechenden Spannungen an den digitalen Controller 7 übermittelt. Der digitale Controller 7 bewertet daraufhin wie in Beispiel 2 den sich aus den gemessenen Ist-Strom-Werten I_{Ist} und der zugehörigen Zeit ergebenden Energiebetrag als auch die über den Last- und/oder Generatorkomponenten 11, 12 abfallenden Spannungen und entscheidet dann, ob ein Kurzschluss besteht oder Stromspitzen vorliegen. Darauf basierend gibt der digitale Controller 7 an die Transistorregler 61, 62 ein Abschaltsignal für die Transistorschalter 31, 32 oder nicht.

### Beispiel 4:

Mit der erfindungsgemäßen Schaltung 1 bzw. mit dem entsprechenden Verfahren ist es möglich, die Transistorschalter 31, 32 und damit die Schaltung 1 abrupt auszuschalten. Dies ist jedoch in manchen Fällen nicht gewollt. Der digitale Controller 7 kann daher in einer weiteren Ausführungsform des erfindungsgemäßen Verfahrens den Transistorreglern 61, 62 Signale zur rampen- oder stufenförmigen Verringerung des Ist-Stroms I_{Ist} vorgeben. Bei einer solchen Softabschaltung wird der Ist-Strom I_{Ist} allmählich auf null verringert. Eine solche Softabschaltung ist für beide Stromrichtungen 21, 22 möglich. Dadurch kann die Gefahr eines Auftretens von Schäden an Elektronikkomponenten der Schaltung 1, insbesondere an den Transistorschaltern 31, 32, stark verringert werden.

### Beispiel 5:

Ebenso wie in Beispiel 4 eine Softabschaltung der Schaltung 1 vorgenommen werden kann, kann die Schaltung 1 auch soft eingeschaltet werden. Bei einer solchen Ausführungsform der Erfindung gibt der digitale Controller 7 den Transistorreglern 61, 62 rampen- oder stufenförmige Einschaltsignale vor, welche diese in entsprechende Gatespannungen für die Transistorschalter 31, 32 umsetzen. Dies hat den Vorteil, dass insbesondere dann, wenn die Schaltung 1 wenigstens eine kapazitive Last- und/oder Generatorkomponente 11, 12 aufweist, die Transistorschalter 31, 32 nicht so schnell kaputt gehen und auch andere Komponenten, die sich im Strompfad befinden, kaum gestresst werden. Durch die rampen- oder stufenförmige Einschaltung der Schaltung 1 erhält die jeweilige kapazitive Last- und/oder Generatorkomponente 11, 12 nicht sofort den vollen Strom und kann allmählich aufgeladen werden. Liegt kein Kurzschluss vor, kann der Ist-Strom I_{Ist} erhöht werden, bei Kurzschluss wird abgeschaltet oder der Ist-Strom I_{Ist} wird auf eine vorhergehende Stufe abgesenkt.

### Beispiel 6:

Da man bei der vorliegenden Erfindung jedem der Transistorregler 61, 62 einen eigenen Soll-Strom I_{Soll1} bzw. I_{Soll2} vorgeben kann, kann ein Fließen des Ist-Stroms I_{Ist} nur in der ersten Stromrichtung 21 von A nach B oder nur in der zweiten Stromrichtung von B nach A erlaubt werden.

### Beispiel 7:

In einer weiteren Ausführungsform der Erfindung können die Transistorregler 61, 62 und die Transistorschalter 31, 32 jeweils aus mehreren, wie beispielsweise fünf, parallel zueinander geschalteten Transistorregler- und Transistorschaltereinheiten zusammengesetzt sein. Über diese kaskadierten Transistorregler- und Transistorschaltereinheiten kann stufenweise die Stromstärke des Ist-Stroms I_{Ist} erhöht werden, z. B. in 200 A-Stufen bis auf 1 kA. Man kann solche Transistorregler- und Transistorschaltereinheiten beliebig aufstacken bzw. erweitern, um die Stromstärke zu erhöhen.

### Beispiel 8:

In einer anderen Ausführungsform der Erfindung ist es auch möglich, die Transistorschalter 31, 32 zu kaskadieren, indem jeweils mehrere Halbleitertransistoren parallel zueinander geschaltet werden, um jeweils einen der Transistorschalter 31, 32 auszubilden.

Die erfindungsgemäße Schaltung 1 kann in einer weiteren Ausführungsform ferngesteuert werden.

Die Schaltung 1 ist unabhängig davon, ob Gleich- oder Wechselspannung verwendet wird.

## Patentansprüche

1. Verfahren zur Stromkontrolle mit einer Schaltung (1) mit einer ersten Last- und/oder Generatorkomponente (11) und einer zweiten Last- und/oder Generatorkomponente (12), zwischen welchen ein Strom in einer ersten Stromrichtung (21) oder in einer zweiten Stromrichtung (22) fließen kann, und zwei in Reihe zwischen der ersten Last- und/oder Generatorkomponente (11) und der zweiten Last- und/oder Generatorkomponente (12) geschalteten Transistorschaltern (31, 32), deren Source- bzw. Emitteranschlüsse (312, 322) elektrisch kurzgeschlossen sind, wobei Gatespannungen an Gateanschlüssen (311, 321) der Transistorschalter (31, 32) durch den Transistorschaltern (31, 32) jeweils zugeordnete, analoge Transistorregler (61, 62) eingestellt und damit ein Ist-Strom (I_{Ist}) durch die Transistorschalter (31, 32) geregelt wird, **dadurch gekennzeichnet, dass** der Ist-Strom (I_{Ist}) mit einer Strommesseinrichtung (4) zwischen den Transistorschaltern (31, 32) gemessen wird, dieser an die Transistorregler (61, 62) übergeben wird, wobei der Ist-Strom (I_{Ist}) oder der verstärkte Ist-Strom (I_{Ist}) einem ersten der Transistorregler (61) als erstes Eingangssignal des ersten Transistorreglers (61) und invertiert einem zweiten der Transistorregler (62) als erstes Eingangssignal des zweiten Transistorreglers (62) übergeben wird, den Transistorreglern (61, 62) durch einen digitalen Controller (7) jeweils ein erster Soll-Strom (I_{Soll1}) für die erste Stromrichtung (21) und ein zweiter Soll-Strom (I_{Soll2}) für die zweite Stromrichtung (22) vorgegeben wird, und von den Transistorreglern (61, 62) in Abhängigkeit von der jeweiligen Differenz zwischen dem Ist-Strom (I_{Ist}) und dem jeweiligen Soll-Strom (I_{Soll1}, I_{Soll2}) entsprechende Gatespannungen für die Transistorschalter (31, 32) eingestellt und damit der Ist-Strom (I_{Ist}) durch die Transistorschalter (31, 32) geregelt wird.

2. Verfahren nach Anspruch 1, **dadurch gekennzeichnet, dass** der Ist-Strom (I_{Ist}) kontinuierlich an den digitalen Controller (7) übermittelt wird.

3. Verfahren nach Anspruch 1, **dadurch gekennzeichnet, dass** Spannungsabfälle über der ersten Last- und/oder Generatorkomponente (11) und über der zweiten Last- und/oder Generatorkomponente (12) erfasst und dem digitalen Controller (7) übermittelt werden.

4. Verfahren nach einem der vorhergehenden Ansprüche, **dadurch gekennzeichnet, dass** der digitale Controller (7) den Ist-Strom (I_{Ist}) und gegebenenfalls die Spannungsabfälle über der ersten Last- und/oder Generatorkomponente (11) und über der zweiten Last- und/oder Generatorkomponente (12) über einen eine galvanische Trennung ausbildenden Digitalkoppler (72) an eine externe Steuereinheit (8) kontinuierlich übermittelt.

5. Verfahren nach einem der vorhergehenden Ansprüche, **dadurch gekennzeichnet, dass** dann, wenn der Ist-Strom (I_{Ist}) über eine vorbestimmte Zeitspanne hinweg den jeweils vorgegebenen Soll-Strom (I_{Soll1}, I_{Soll2}) überschreitet, durch den digitalen Controller (7) ein Ausschaltsignal an wenigstens einen der Transistorregler übermittelt wird.

6. Verfahren nach Anspruch 3, **dadurch gekennzeichnet, dass** dann, wenn der Ist-Strom (I_{Ist}) über eine vorbestimmte Zeitspanne hinweg den jeweils vorgegebenen Soll-Strom (I_{Soll1}, I_{Soll2}) überschreitet und der Spannungsabfall über der diesem Soll-Strom (I_{Soll1}, I_{Soll2}) zugeordneten Last- und/oder Generatorkomponente (11, 12) einen Spannungssollwert unterschreitet, durch den digitalen Controller (7) der jeweilige Soll-Strom (I_{Soll1}, I_{Soll2}) auf null gesetzt wird.

7. Verfahren nach einem der vorhergehenden Ansprüche, **dadurch gekennzeichnet, dass** dann, wenn die Schaltung (1) ausgeschaltet wird, durch den digitalen Controller (7) der Soll-Strom (I_{Soll1}, I_{Soll2}) rampen- oder stufenförmig verringert wird.

8. Verfahren nach einem der vorhergehenden Ansprüche, **dadurch gekennzeichnet, dass** dann, wenn die Schaltung (1) eingeschaltet wird, der Soll-Strom (I_{Soll1}, I_{Soll2}) rampen- oder stufenförmig erhöht wird.

9. Schaltung (1) zur Stromkontrolle mit einer ersten Last- und/oder Generatorkomponente (11) und einer zweiten Last- und/oder Generatorkomponente (12), zwischen welchen ein Strom in einer ersten Stromrichtung (21) oder in einer zweiten Stromrichtung (22) fließen kann, und zwei in Reihe zwischen der ersten Last- und/oder Generatorkomponente (11) und der zweiten Last- und/oder Generatorkomponente (12) geschalteten Transistorschaltern (31, 32), deren Source- bzw. Emitteranschlüsse (312, 322) elektrisch kurzgeschlossen sind, und den Transistorschaltern (31, 32) jeweils zugeordneten, analogen Transistorreglern (61, 62) zum Einstellen von Gatespannungen und damit Regeln eines Ist-Stroms (I_{Ist}) durch die Transistorschalter (31, 32), **dadurch gekennzeichnet, dass** zur Messung des Ist-Stroms (I_{Ist}) zwischen die Transistorschalter (31, 32) eine Strommesseinrichtung (4) geschaltet ist, deren Ausgang mit jeweiligen Reglereingängen (611, 621) der Transistorregler zum (61, 62) Übermitteln des jeweils gemessenen Ist-Stroms (I_{Ist}) verbunden ist, wobei der Ist-Strom (I_{Ist}) oder der verstärkte Ist-Strom (I_{Ist}) einem ersten der Transistorregler (61) als erstes Eingangssignal des ersten Transistorreglers (61) und invertiert einem zweiten der Transistorregler (62) als erstes Eingangssignal des zweiten Transistorreglers (62) übergeben wird, und Reglereingänge (611, 621) der Transistorregler (61, 62) mit einem digitalen Controller (7) zur Vorgabe wenigstens eines Soll-Stroms (I_{Soll1}, I_{Soll2}) verbunden sind.

10. Schaltung nach Anspruch 9, **dadurch gekennzeichnet, dass** der Controller (7) mit der Strommesseinrichtung (4) direkt oder über einen Strommessverstärker (5) verbunden ist.

11. Schaltung nach Anspruch 9, **dadurch gekennzeichnet, dass** parallel zu der ersten Last- und/oder Generatorkomponente (11) ein erstes Spannungsmessgerät (91) und parallel zu der zweiten Last- und/oder Generatorkomponente (12) ein zweites Spannungsmessgerät (92) geschaltet ist.

12. Schaltung nach einem der Ansprüche 9 bis 11, **dadurch gekennzeichnet, dass** die Transistorregler (61, 62) jeweils Pl- oder PID-Regler mit Operationsverstärker sind.

13. Schaltung nach einem der Ansprüche 9 bis 12, **dadurch gekennzeichnet, dass** die Transistorregler (61, 62) und die Transistorschalter (31, 32) aus mehreren, parallel zueinander geschalteten Transistorregeleinheiten und Transistorschaltereinheiten zusammengesetzt sind.

14. Schaltung nach einem der Ansprüche 9 bis 13, **dadurch gekennzeichnet, dass** wenigstens einer der Transistorschalter (31, 32) aus mehreren, parallel zueinander geschalteten Halbleitertransistoren zusammengesetzt ist.

## Claims

1. Method for current control with a circuit (1) with a first load and/or generator component (11) and a second load and/or generator component (12), between which a current can flow in a first current direction (21) or in a second current direction (22), and two transistor switches (31, 32) connected in series between the first load and/or generator component (11) and the second load and/or generator component (12), wherein the source or emitter terminals (312, 322) of the transistor switches (31, 32) are electrically short-circuited, wherein gate voltages at gate terminals (311, 321) of the transistor switches (31, 32) are set by analog transistor controllers (61, 62) associated to the transistor switches (31, 32), respectively, and thus an actual current (I_{Ist}) is controlled by the transistor switches (31, 32), **characterized in that** the actual current (I_{Ist}) is measured with a current measuring device (4) between the transistor switches (31, 32) and said measured actual current (I_{Ist}) is forwarded to the transistor controllers (61, 62), wherein the actual current (I_{Ist}) or the actual current (I_{Ist}) as amplified value is forwarded to a first one of the transistor controllers (61) as first input signal of the first transistor controller (61) and is forwarded invertedly to a second one of the transistor controllers (62) as first input signal of the second transistor controller (62), wherein the transistor controllers (61, 62) are each given a first target current (I_{Soll1}) for the first current direction (21) and a second target current (I_{Soll2}) for the second current direction (22) by a digital controller (7), and the transistor controllers (61, 62) set corresponding gate voltages for the transistor switches (31, 32) depending on the respective difference between the actual current (I_{Ist}) and the respective target current (I_{Soll1}, I_{Soll2}), and thus the actual current (I_{Ist}) is controlled by the transistor switches (31, 32).

2. Method according to claim 1, **characterized in that** the actual current (I_{Ist}) is forwarded continuously to the digital controller (7).

3. Method according to claim 1, **characterized in that** voltage drops across the first load and/or generator component (11) and across the second load and/or generator component (12) are detected and transmitted to the digital controller (7).

4. Method according to one of the preceding claims, **characterized in that** the digital controller (7) continuously transmits the actual current (I_{Ist}) and, if applicable, the voltage drops across the first load and/or generator component (11) and across the second load and/or generator component (12) to an external control unit (8) via a digital coupler (72) forming a galvanic separation.

5. Method according to one of the preceding claims, **characterized in that** when the actual current (I_{Ist}) exceeds the respectively predetermined target current (I_{Soll1}, I_{Soll2}) over a predetermined period of time, a switch-off signal is transmitted by the digital controller (7) to at least one of the transistor controllers (61, 62).

6. Method according to claim 3, **characterized in that** when the actual current (I_{Ist}) exceeds the respectively specified target current (I_{Soll1}, I_{Soll2}) over a predetermined period of time and the voltage drop across the load and/or generator component (11, 12) associated to this target current (I_{Soll1}, I_{Soll2}) falls below a voltage target value, the respective target current (I_{Soll1}, I_{Soll2}) is set to zero by the digital controller (7).

7. Method according to one of the preceding claims, **characterized in that** when the circuit (1) is switched off, the target current (I_{Soll1}, I_{Soll2}) is reduced in a ramp or step manner by the digital controller (7).

8. Method according to one of the preceding claims, **characterized in that** when the circuit (1) is switched on, the target current (I_{Soll1}, I_{Soll2}) is increased in a ramp or step manner.

9. Circuit (1) for current control with a first load and/or generator component (11) and a second load and/or generator component (12), between which a current can flow in a first current direction (21) or in a second current direction (22), and two transistor switches (31, 32) connected in series between the first load and/or generator component (11) and the second load and/or generator component (12), wherein the source or emitter terminals (312, 322) of the transistor switches (31, 32) are electrically short-circuited, and analog transistor controllers (61, 62) associated to the transistor switches (31, 32) for setting gate voltages and thus controlling an actual current (I_{Ist}) through the transistor switches (31, 32), **characterized in that** for measuring the actual current (I_{Ist}) a current measuring device (4) is connected between the transistor switches (31, 32), wherein the output of the current measuring device (4) is connected to respective controller inputs (611, 621) of the transistor controllers (61, 62) for transmitting the respectively measured actual current (I_{Ist}), wherein the actual current (I_{Ist}) or the actual current (I_{Ist}) as amplified value is forwarded to a first one of the transistor controllers (61) as first input signal of the first transistor controller (61) and is forwarded invertedly to a second one of the transistor controllers (62) as first input signal of the second transistor controller (62), and controller inputs (611, 621) of the transistor controllers (61, 62) are connected to a digital controller (7) for specifying at least one target current (I_{Soll1}, I_{Soll2}).

10. Circuit according to claim 9, **characterized in that** the controller (7) is connected with the current measuring device (4) directly or via a current amplifier (5).

11. Circuit according to claim 9, **characterized in that** a first voltage measuring device (91) is connected in parallel to the first load and/or generator component (11) and a second voltage measuring device (92) is connected in parallel to the second load and/or generator component (12).

12. Circuit according to one of claims 9 to 11, **characterized in that** the transistor controllers (61, 62) are each PI or PID controllers with operational amplifier.

13. Circuit according to one of claims 9 to 12, **characterized in that** the transistor controllers (61, 62) and the transistor switches (31, 32) are composed of several transistor control units and transistor switch units connected in parallel to one another.

14. Circuit according to one of claims claim 9 to 13, **characterized in that** at least one of the transistor switches (31, 32) is composed of several semiconductor transistors connected in parallel to one another.

## Revendications

1. Procédé de commande de courant comportant un circuit (1) avec un premier composant de charge et/ou de générateur (11) et un deuxième composant de charge et/ou de générateur (12), entre lesquels un courant peut circuler dans une première direction de courant (21) ou dans une deuxième direction de courant (22), et deux commutateurs de transistor (31, 32) connectés en série entre le premier composant de charge et/ou de générateur (11) et le deuxième composant de charge et/ou de générateur (12), les bornes de source et/ou d'émetteur (312, 322) des commutateurs de transistor (31, 32) étant court-circuitées électriquement, des tensions de grille aux bornes de grille (311, 321) des commutateurs de transistor (31, 32) étant ajustées par des contrôleurs analogiques (61, 62) associés aux commutateurs de transistor (31, 32) respectivement, et un courant réel (I_{Ist}) étant ainsi contrôlé par les commutateurs de transistor (31, 32), **caractérisé en ce que** le courant réel (I_{Ist}) est mesuré par un dispositif de mesure de courant (4) entre les commutateurs de transistor (31, 32) et ce courant réel (I_{Ist}) est transmis aux contrôleurs de transistor (61, 62), le courant réel (I_{Ist}) ou le courant réel (I_{Ist}) comme valeur amplifié étant transmis à un premier des contrôleurs de transistor (61) comme premier signal d'entrée du premier contrôleur de transistor (61) et étant transmis inversé à un deuxième des contrôleurs de transistor (62) comme premier signal d'entrée du deuxième contrôleur de transistor (62), un premier courant de consigne (I_{Soll1}) pour la première direction de courant (21) et un deuxième courant de consigne (I_{Soll2}) pour la deuxième direction de courant (22) étant prédéfinis pour les contrôleurs de transistor (61, 62) par un contrôleur numérique (7), et les contrôleurs de transistor (61, 62) ajustant des tensions de grille pour les commutateurs de transistor (31, 32) dépendent de la différence respective entre le courant réel (I_{Ist}) et le courant de consigne (I_{Soll1}, I_{Soll2}) respectif, et ainsi le courant réel (I_{Ist}) étant contrôlé par les commutateurs de transistor (31, 32).

2. Procédé selon la revendication 1, **caractérisé en ce que** le courant réel (I_{Ist}) est transmis au contrôleur numérique (7) continument.

3. Procédé selon la revendication 1, **caractérisé en ce que** les chutes de tension du premier composant de charge et/ou de générateur (11) au deuxième composant de charge et/ou de générateur (12) sont détectées et transmises au contrôleur numérique (7).

4. Procédé selon l'une des revendications précédentes, **caractérisé en ce que** le contrôleur numérique (7) transmet continument le courant réel (I_{Ist}) et éventuellement les chutes de tension du premier composant de charge et/ou de générateur (11) au deuxième composant de charge et/ou de générateur (12) à une unité de commande externe (8) via un coupleur numérique (72) formant une séparation galvanique.

5. Procédé selon l'une des revendications précédentes, **caractérisé en ce que** lorsque le courant réel (I_{Ist}) dépasse le courant de consigne (I_{Soll1}, I_{Soll2}) respectivement prédéterminé pendant une période de temps prédéterminée, un signal d'arrêt est transmis par le contrôleur numérique (7) à au moins un des contrôleurs de transistors (61, 62).

6. Procédé selon la revendication 3, **caractérisé en ce que** lorsque le courant réel (I_{Ist}) dépasse le courant de consigne (I_{Soll1}, I_{Soll2}) respectivement spécifié pendant une période de temps prédéterminée et la chute de tension aux composant de charge et/ou de générateur (11, 12) associé à ce courant de consigne (I_{Soll1}, I_{Soll2}) tombe en dessous d'un point de consigne de tension, le de consigne (I_{Soll1}, I_{Soll2}) respectif est mis à zéro par le contrôleur numérique (7).

7. Procédé selon l'une des revendications précédentes, **caractérisé en ce que** lorsque le circuit (1) est mis hors tension, le courant de consigne (I_{Soll1}, I_{Soll2}) est réduit par le contrôleur numérique (7) de manière progressive ou par paliers.

8. Procédé selon l'une des revendications précédentes, **caractérisé en ce que** lorsque le circuit (1) est mis sous tension, le courant de consigne (I_{Soll1}, I_{Soll2}) est augmenté de manière progressive ou par paliers.

9. Circuit (1) de commande de courant avec un premier composant de charge et/ou de générateur (11) et un deuxième composant de charge et/ou de générateur (12), entre lesquels un courant peut circuler dans une première direction de courant (21) ou dans une deuxième direction de courant (22), et deux commutateurs de transistor (31, 32) connectés en série entre le premier composant de charge et/ou de générateur (11) et le deuxième composant de charge et/ou de générateur (12), les bornes de source et/ou d'émetteur (312, 322) des commutateurs de transistor (31, 32) étant court-circuitées électriquement, et avec des contrôleurs analogiques (61, 62) associés aux commutateurs de transistor (31, 32) pour ajuster des tensions de grille et ainsi contrôler un courant réel (I_{Ist}) par les commutateurs de transistor (31, 32), **caractérisé en ce que** pour mesurer le courant réel (I_{Ist}) un dispositif de mesure de courant (4) est connecté entre les commutateurs de transistor (31, 32), dont la sortie est connectée aux entrées de commande (611, 621) respectives des contrôleurs de transistor (61, 62) pour transmettre le courant réel (I_{Ist}) respectivement mesuré, le courant réel (I_{Ist}) ou le courant réel (I_{Ist}) comme valeur amplifié étant transmis à un premier des contrôleurs de transistor (61) comme premier signal d'entrée du premier contrôleur de transistor (61) et étant transmis inversé à un deuxième des contrôleurs de transistor (62) comme premier signal d'entrée du deuxième contrôleur de transistor (62), et des entrées de commande (611, 621) des contrôleurs de transistor (61, 62) sont connectées à un contrôleur numérique (7) pour spécifier au moins un courant de consigne (I_{Soll1}, I_{Soll2}).

10. Circuit selon la revendication 9, **caractérisé en ce que** le contrôleur numérique (7) est connecté au dispositif de mesure de courant (4) directement ou via un amplificateur de mesure de courant (5).

11. Circuit selon la revendication 9, **caractérisé en ce que** un premier dispositif de mesure de tension (91) est connecté en parallèle au premier composant de charge et/ou de générateur (11) et un deuxième dispositif de mesure de tension (92) est connecté en parallèle au deuxième composant de charge et/ou de générateur (12).

12. Circuit selon l'une des revendications 9 à 11, **caractérisé en ce que** les contrôleurs de transistor (61, 62) sont chacun des contrôleurs PI ou PID avec des amplificateurs opérationnels.

13. Circuit selon l'une des revendications 9 à 12, **caractérisé en ce que** les contrôleurs de transistor (61, 62) et les commutateurs de transistor (31, 32) sont composés de plusieurs unités de commande à transistors et unités de commutation à transistors connectées en parallèle les unes aux autres.

14. Circuit selon l'une des revendications 9 à 13, **caractérisé en ce que** au moins un des commutateurs de transistor (31, 32) est composé de plusieurs transistors semi-conducteurs connectés en parallèle les uns aux autres.
